# EUROPÄISCHE PATENTSCHRIFT

(11) **EP 0 895 113 B1**
(45) Veröffentlichungstag und Bekanntmachung des Hinweises auf die Patenterteilung: **25.02.2004**
(21) Anmeldenummer: 98112734.3
(22) Anmeldetag: 09.07.1998
(51) Int. Cl.: G02B 7/00, G02B 7/02, G03F 7/20, H01S 3/034

(54) **Optik-Fassung mit UV-Kleber und Schutzschicht**
Optical mount with UV curable adhesive and protective coating
Monture optique avec adhésif durcissable par rayonnement ultraviolet et couche de protection

(30) Priorität: 01.08.1997 DE 19733490
(43) Veröffentlichungstag der Anmeldung: 03.02.1999
(73) Patentinhaber: Carl Zeiss SMT AG, 73447 Oberkochen (DE)
(72) Erfinder: Bauer, Harry, Dr., 73432 Aalen-Ebnat (DE); Kraus, Sascha, 73431 Aalen (DE); Keck, Hans G., 89231 Neu-Ulm (DE); Endler, Jörg, 73540 Heubach (DE); Weippert, Hans-Joachim, 73431 Aalen (DE)
(74) Vertreter: Gnatzig, Klaus

(56) Entgegenhaltungen:
- EP-A- 0 660 188
- US-A- 5 430 303
- PATENT ABSTRACTS OF JAPAN vol. 1997, no. 07, 31. Juli 1997 (1997-07-31) -& JP 09 080207 A (USHIO INC), 28. März 1997 (1997-03-28)
- PATENT ABSTRACTS OF JAPAN vol. 012, no. 037 (C-473), 4. Februar 1988 (1988-02-04) -& JP 62 184079 A (OLYMPUS OPTICAL CO LTD), 12. August 1987 (1987-08-12)
- PATENT ABSTRACTS OF JAPAN vol. 013, no. 267 (M-840), 20. Juni 1989 (1989-06-20) -& JP 01 070222 A (ASAHI GLASS CO LTD), 15. März 1989 (1989-03-15)

## Beschreibung

Die Erfindung betrifft eine Baugruppe bestehend aus einem Halter - insbesondere einer Fassung - und einem mittels eines Klebers verklebten transparenten, vorzugsweise optischen, Bauteil, das im ultravioletten Spektralbereich transmittiert, wobei der Kleber durch UV-Licht mit einer bestimmten Spektralverteilung aushärtbar ist.

Solche Baugruppen bilden u.a. gefaßte Linsen und dergleichen von Beleuchtungssystemen und Projektionsobjektiven für die Mikrolithographie.

Z.B. für Auto- und Architekturglas ist die Klebeverbindung mit Fassung bekannt, wobei der Klebstoff durch UV-absorbierende Füllstoffe und Schutzschichten vor der Einwirkung von solarer UV-Strahlung geschützt wird.

Dünne Schichten, also insbesondere Schichten mit Dicken im Mikrometerbereich aus Dielektrika, die durch Vakuum-Bedampfen, Sputtern, PVD oder CVD aufgebracht werden, sind auch auf dem Gebiet der Optik bekannt.

Ausweislich Naumann, Schröder, Bauelemente der Optik, München und Wien 1983, Seite 72 haben derartige Schichten aus Kryolith, Magnesiumfluorid, Cerfluorid, Zinksulfid und Titandioxid untere Durchlässigkeitsgrenzen von 0,12 bis 0,4 µm. Tantalpentoxid, Hafniumdioxid und Mischungen davon transmittieren laut SU 48 23 642/33 ab 0,3 µm bzw. 0,32 µm.

Allgemein sind die genauen Reflexions-, Absorptions- und Transmissionsspektren dieser dünnen Schichten im DUV-Bereich nicht bekannt, da Einflüsse der Substrate und der Spektrometer-/Monochromator-Bauteile schwer erfaßbar sind, und diese Materialien außerhalb des vorgesehenen Anwendungsbereichs nicht geprüft werden.

Es hat sich gezeigt, daß bekannte Fassungskleber auf Epoxidharz-Basis, die mit UV-Licht der Hg-I-Linie ausgehärtet werden können, unter dem DUV-Streulicht bei 248 nm und mehr noch bei 193 nm in DUV-Projektionsbelichtungsanlagen erheblich strahlungsgeschädigt werden können und durch ihr Versagen die Lebensdauer dieser aufwendigen Systeme begrenzen.

DUV-absorbierende Füllstoffe in der Klebermasse verhindern nicht das Versagen der Grenzschicht Quarzglas-Kleber.

Aufgabe der Erfindung ist es, eine gattungsgemäße Baugruppe bereitzustellen, bei der der Kleber mit UV-Licht, besonders Hg-I-Linie, ausgehärtet werden kann, und die doch gegen UV-Licht eines Nutz-Spektralbereichs, besonders im kurzwelligeren DUV-Bereich, stabil ist. Die Reflexion von Licht aus dem Klebebereich soll weitgehendst unterbleiben, da solches Streulicht in der Optik störend wirkt. Ein Herstellungsverfahren dazu und eine Verwendung sollen angegeben werden.

Gelöst wird diese Aufgabe durch eine Baugruppe mit den Merkmalen des Anspruchs 1, durch das Herstellverfahren des Anspruchs 12 und durch die Verwendung der Ansprüche 15 und 16.

Vorteilhafte Ausführungen sind Gegenstand der Unteransprüche 2 bis 11 und 13, 14.

Es gelingt somit also, ausgehend von der bewährten Fassungstechnik mit UV-härtendem Kleber, durch Einführung nur eines einzigen Herstellschritts der Beschichtung, der zudem gut in die ohnehin erforderliche Behandlung zum Aufbringen von Antireflexschichten integriert werden kann, eine DUV-taugliche dauerfeste Ausführung der Linsenfassung zu verwirklichen.

Näher erläutert wird die Erfindung anhand der Zeichnung.

Es zeigen:
- Figur 1: in einem schematischen Ausschnitt eine erfindungsgemäße Baugruppe;
- Figur 2: das Transmissionsspektrum einer geeigneten Ta₂ O₅-Schicht.

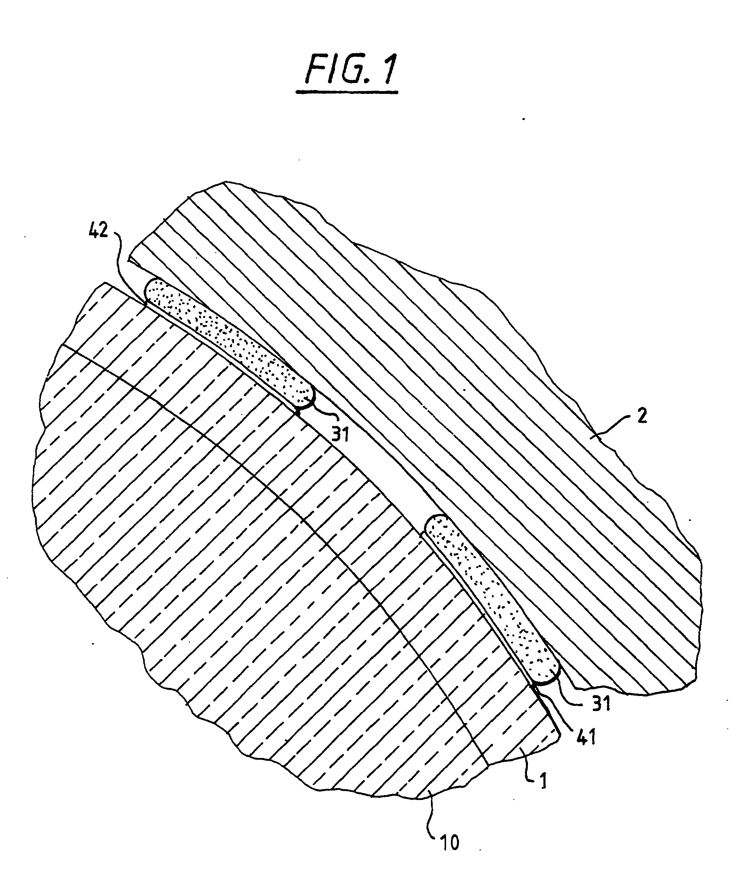

Die in Figur 1 mit einem signifikanten Ausschnitt schematisch dargestellte Baugruppe besteht aus einem transparenten Bauteil 1, nämlich einer Linse, einer Planplatte, einem Prisma, einem Manginspiegel oder einem transmittierenden diffraktiven optischen Element in einer Fassung 2 aus Metall oder Keramik/Glaskeramik, die nicht UV-transparent ist. Diese Teile 1 und 2 sind mit Kleberschichten 31, 32, die abschnittsweise über den Rand des Bauteils 1 verteilt oder durchgängig am Stück ausgebildet sind, kraftschlüssig verbunden. Die Kleberschichten 31, 32 bestehen aus UV-härtbarem (bzw. UV-gehärtetem) Kleber auf Epoxidharz-Basis, wie z.B. dem Omnifit UV-4000 von Omnitechnic GmbH, Hannover.

Der Kleber in dieser Anordnung (1, 2, 31, 32) kann mit Hg-I-Licht einer Quecksilberhochdrucklampe durch das transparente optische Bauteil 1 hindurch ausgehärtet werden.

Da der Kleber gegen Licht mit kürzerer Wellenlänge, insbesondere das Licht von Excimer-Lasern bei 248 nm oder 193 nm - wie es bei Projektionsbelichtungsanlagen für die Mikrolithographie der neuesten Bauformen benötigt wird - photochemisch unstabil ist, wird eine Kleberschutzschicht 41, 42 für jede Kleberschicht 31, 32 benötigt und erfindungsgemäß vorgesehen. Diese kann entweder direkt an der Stelle der späteren Verklebung angebracht werden oder auf der gegenüberliegenden Fläche des transparenten Bauteils.

Als Schutzschicht ist beispielsweise eine dünne Schicht aus Tantalpentoxid (Ta₂ O₅) geeignet, die wie eine optische Schicht (zur Entspiegelung usw.) aufgebracht wird. Sie kann beispielsweise konventionell im Vakuum als Einfachschicht aufgedampft werden.

Die Dicke wird bestimmt als n x Lambda/2 für die optische Weglänge bei der Aushärtewellenlänge von 365 nm mit n = 1 für die Nutzwellenlänge 193 nm, n = 2 für die Nutzwellenlänge 248 nm.

Damit wird eine hohe Transmission von über 85 % bei der Aushärtewellenlänge 365 nm, eine sehr niedrige Transmission unter 2 % bei der Nutzwellenlänge 248 nm und darunter, zugleich eine hohe Absorption und eine durchgängig geringe Reflexion bei beiden Spektralbereichen erreicht.

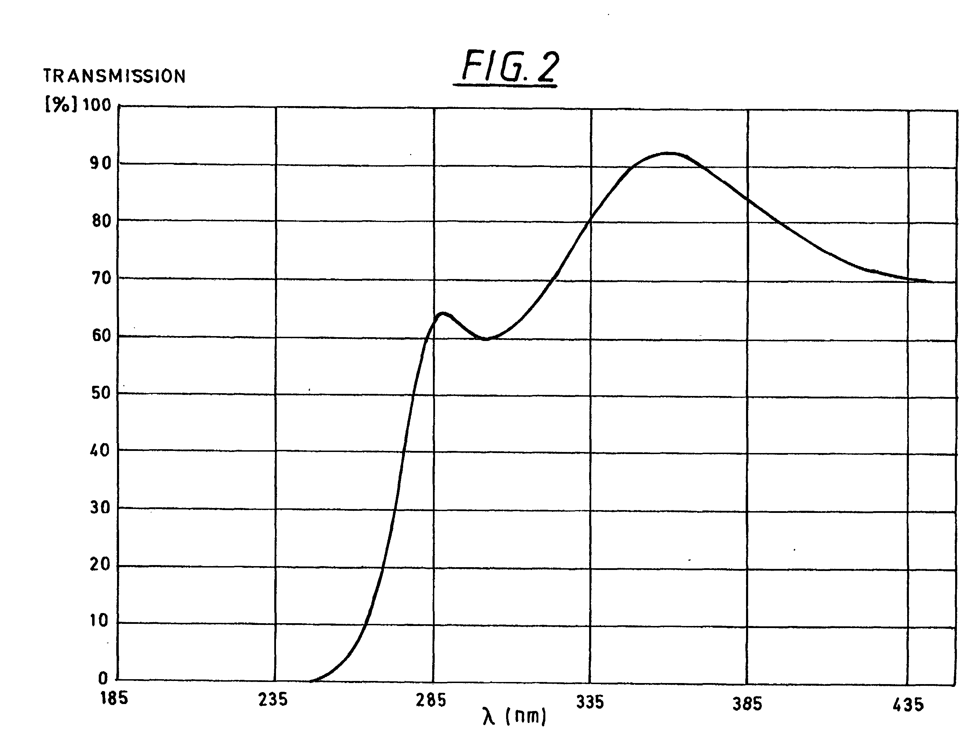

Figur 2 zeigt das Transmissionsspektrum einer solchen Tantalpentoxid-Schicht auf einseitig unbeschichtetem Suprasil-Quarzglas, gemessen unter 7° zur Flächennormalen.

Weiter reduzierte Reflexion kann durch gezielte Mehrfachschichten (Entspiegelungsschichten) erreicht werden.

Die Zug- und Zugscherfestigkeit der Schicht sollte mindestens 10 N/mm² auf Quarzglas betragen, damit die Haltekraft der Klebeverbindung nicht herabgesetzt wird.

Die Schicht ist chemisch stabil gegenüber den Umweltbedingungen bei Herstellung und Betrieb von DUV-Projektionsbelichtungsanlagen für die Mikrolithographie.

Eine derartige Tantalpentoxid-beschichtete Baugruppe übersteht nun eine Bestrahlung mit 248 nm-DUV-Licht so gut, daß die Lebensdauer des Gesamtsystems nicht durch die Lebensdauer der Klebeverbindung limitiert wird.

Für die Funktion des optischen Bauteils 1 ist es ganz wesentlich, daß die der Transmission dienenden Funktionsflächen 10 nicht mit der absorbierenden Tantalpentoxid-Schicht kontaminiert werden. Die Bedampfung geschieht daher mit einer Vorrichtung, die diese Flächen 10 hermetisch versiegelt, z.B. mit elastisch verspannten Ringschneiden.

Die Kleberschutzschicht 41, 42 wird vorzugsweise vor den Entspiegelungsschichten für die transmittierenden Flächen 10 aufgebracht, damit eine eventuelle Kontamination weniger gravierend ist.

Die Verwendung von Tantalpentoxid auf Quarzglas wie auch die Wellenlängen 365 nm, 248 nm oder 193 nm sind dabei bevorzugte Beispiele. Andere geeignete Stoffe, deren Transmission im DUV-Bereich abnimmt, sind beispielhaft in der Einleitung beschrieben. Wie die angegebene SU-Schrift zeigt, kommen dabei auch Stoffmischungen in Betracht.

Ebenso sind als transparentes Substrat neben Quarzglas u.a. auch Kalziumfluorid und Germaniumdioxid-Glas (DE 196 33 128.5, Schuster) geeignet.

Neben der Verwendung der erfindungsgemäßen Baugruppen in der Projektions-Mikrolithographie sind sie besonders auch für DUV-Laseroptiken, hier besonders für Austrittsfenster von Excimer-Lasern, geeignet.

## Patentansprüche

1. Baugruppe, bestehend aus einem Halter (2) und einem mittels eines Klebers (31, 32) mit dem Halter verklebten transparenten Bauteil (1), das im ultravioletten Spektralbereich transmittiert, wobei der Kleber (31, 32) durch UV-Licht mit einer bestimmten Spektralverteilung aushärtbar ist, **dadurch gekennzeichnet, daß** auf dem transparenten Bauteil (1) im Bereich des Klebers (31, 32) eine in Dünnschichttechnik aufgebrachte Schicht (41, 42) vorhanden ist, die UV-Licht aus dem zur Aushärtung des Klebers (31, 32) geeigneten Spektralbereich transmittiert und UV-Licht aus einem Nutz-Spektralbereich innerhalb des vom transparenten Bauteil (1) transmittierten Spektralbereichs hochgradig reflektiert und oder absorbiert.

2. Baugruppe nach Anspruch 1, wobei der Halter aus einer Fassung (2) besteht und das mittels UV-härtbarem Kleber (31, 32) verklebte Bauteil ein transparentes optisches Element (1) ist und wobei das optische Element (1) im Bereich des Klebers (31, 32) die dünne Schicht (41, 42) trägt und die Schicht bei der Hg-I-Linie mehr als 60 % transmittiert und bei Wellenlängen unter 250 nm weniger als 5 %, vorzugsweise weniger als 2 %, transmittiert.

3. Baugruppe nach Anspruch 1, wobei die Schicht (41, 42) im Nutz-Spektralbereich weniger als 5 %, vorzugsweise weniger als 2 % transmittiert.

4. Baugruppe nach mindestens einem der Ansprüche 1-3, wobei die Schicht (41, 42) im zur Aushärtung geeigneten Spektralbereich über 50 %, vorzugsweise über 80 %, Transmission erreicht.

5. Baugruppe nach mindestens einem der Ansprüche 1-4, wobei die Schicht (41, 42) eine Transmissionskante zwischen dem Nutz-Spektralbereich und dem vorzugsweise langwelligeren zur Aushärtung geeigneten Spektralbereich aufweist.

6. Baugruppe nach mindestens einem der Ansprüche 1-5, wobei die Schicht (41, 42) in das transparente Bauteil (1) weniger als 10 % reflektiert.

7. Baugruppe nach mindestens einem der Ansprüche 1-6, wobei der Nutz-Spektralbereich die Excimer-Laser-Linien bei 248 nm oder 193 nm umfaßt und der zur Aushärtung des Klebers geeignete Spektralbereich die Hg-I-Linie bei 365 nm umfaßt.

8. Baugruppe nach mindestens einem der Ansprüche 1-7, wobei die Schicht (41, 42) durch Bedampfen, Sputtern, PVD-Abscheidung oder CUD-Abscheidung hergestellt ist.

9. Baugruppe nach mindestens einem der Ansprüche 1-8, wobei die Schicht (41, 42) aus Tantalpentoxid, Hafniumdioxid, Titandioxid, Zinksulfid, Cerfluorid, Kryolith oder Magnesiumfluorid oder Mischungen davon besteht.

10. Baugruppe nach Anspruch 9, wobei die Schicht (41, 42) bei einer Temperatur des transparenten Bauteils von unter 100° C aufgebracht ist.

11. Baugruppe nach mindestens einem der Ansprüche 1-10, wobei das transparente Bauteil (1) aus Quarzglas, Kalziumfluorid oder Germaniumdioxid besteht.

12. Herstellverfahren für ein mittels UV-härtbarem Kleber (31, 32) mit einer Fassung (2) verklebtes transparentes optisches Bauteil (1), **dadurch gekennzeichnet, daß** das Bauteil (1) im Bereich der Verklebung (31, 32) in Dünnschichttechnologie mit einer dünnen Schicht (41, 42) belegt wird, welche zur Aushärtung des Klebers (31, 32) geeignetes Licht transmittiert und UV-Licht aus einem Nutz-Spektralbereich, der vorzugsweise kurzwelliger ist, hochgradig reflektiert oder absorbiert.

13. Verfahren nach Anspruch 12, wobei die dünne Schicht (41, 42) eine Einfachschicht ist.

14. Verfahren nach Anspruch 12 oder 13, wobei durch Bedampfen oder Sputtern mit oder ohne Ionen-Unterstützung, durch PVD oder CVD belegt wird.

15. Verwendung einer Baugruppe nach mindestens einem der Ansprüche 1-11 in einer Mikrolithographie-Projektionsbelichtungsanlage.

16. Verwendung einer Baugruppe nach mindestens einem der Ansprüche 1-11 als DUV-Laser-Bauteil, insbesondere als Austrittsfenster.

## Claims

1. Assembly comprising a holder (2) and a transparent component (1), which is adhesively bonded to the holder by means of an adhesive (31, 32) and transmits in the ultraviolet spectral range, the adhesive (31, 32) being curable by using light with a specific spectral distribution, **characterized in that** a layer (41, 42) applied using thin-film technology is present on the transparent component (1) in the region of the adhesive (31, 32), which layer transmits UV light from the spectral range suitable for curing the adhesive (31, 32) and effects a high degree of reflection and/or absorption of UV light from a useful spectral range within the spectral range transmitted by the transparent components (1).

2. Assembly according to Claim 1, the holder comprising a mount (2) and the component adhesively bonded by means of UV-curable adhesive (31, 32) being a transparent optical element (1), and the optical element (1) carrying the thin layer (41,42) in the region of the adhesive (31, 32), and the layer transmitting more than 60% in the case of the Hg-I line and transmitting less than 5%, preferably less than 2%, at wavelengths below 250 nm.

3. Assembly according to Claim 1, the layer (41, 42) transmitting less than 5%, preferably less than 2%, in the useful spectral range.

4. Assembly according to at least one of Claims 1-3, the layer (41, 42) achieving in excess of 50%, preferably in excess of 80%, transmission in the spectral range suitable for curing.

5. Assembly according to at least one of Claims 1-4, the layer (41, 42) having a transmission edge between the useful spectral range and the preferably longer-wave spectral range suitable for curing.

6. Assembly according to at least one of Claims 1-5, the layer (41, 42) reflecting less than 10% into the transparent component (1).

7. Assembly according to at least one of Claims 1-6, the useful spectral range encompassing the Excimer laser lines at 248 nm or 193 nm and the spectral range suitable for curing the adhesive encompassing the Hg-I at 365 nm.

8. Assembly according to at least one of Claims 1-7, the layer (41, 42) being fabricated by vapour deposition, sputtering, PVD deposition or CUD deposition.

9. Assembly according to at least one of Claims 1-8, the layer (41, 42) comprising tantalum pentoxide, hafnium dioxide, titanium dioxide, zinc sulphide, cerium fluoride, cryolith or magnesium fluoride or mixtures thereof.

10. Assembly according to Claim 9, the layer (41, 42) being applied at a temperature of the transparent component of less than 100°C.

11. Assembly according to at least one of Claims 1-10, the transparent component (1) comprises quartz glass, calcium fluoride or germanium dioxide.

12. Method for producing a transparent optical component (1) adhesively bonded to a mount (2) by means of UV-curable adhesive (31, 32), **characterized in that** the component (1) is coated with a thin layer (41, 42) using thin-film technology in the region of the adhesive bond (31, 32), which layer transmits light suitable for curing the adhesive (31, 32) and effects a high degree of reflection or absorption of UV light from a, preferably shorter-wave, useful spectral range.

13. Method according to Claim 12, the thin layer (41, 42) being a monolayer.

14. Method according to Claim 12 or 13, coating being effected by vapour deposition or sputtering with or without ion assistance, by PVD or CVD.

15. Use of an assembly according to at least one of Claims 1-11 in a microlithography projection exposure installation.

16. Use of an assembly according to at least one of Claims 1-11 and a DUV laser component, in particular as an exit window.

## Revendications

1. Sous-ensemble composé d'un support (2) et d'un composant transparent (1) qui transmet dans la plage spectrale des ultraviolets et qui est collé au support à l'aide d'un adhésif (31, 32), l'adhésif (31, 32) pouvant être durci par de la lumière UV ayant une répartition spectrale donnée, **caractérisé en ce qu'**il existe sur le composant transparent (1), au niveau de l'adhésif (31, 32), une couche (41, 42) appliquée selon la technique de la couche mince qui transmet la lumière UV issue de la plage spectrale appropriée pour le durcissement de l'adhésif (31, 32) et réfléchit et/ou absorbe fortement la lumière UV issue d'une plage spectrale utile à l'intérieur de la plage spectrale transmise par le composant transparent (1).

2. Sous-ensemble selon la revendication 1, le support étant composé d'une monture (2) et le composant collé à l'aide d'un adhésif (31, 32) durcissable par rayonnement UV étant un élément optique transparent (1) et l'élément optique (1) comportant la couche mince (41, 42) dans la zone de l'adhésif (31, 32) et la couche transmettant plus de 60 % au niveau de la ligne Hg-I et transmettant moins de 5 %, de préférence moins de 2 % à des longueurs d'onde inférieures à 250 nm.

3. Sous-ensemble selon la revendication 1, la couche (41, 42) transmettant moins de 5 %, de préférence moins de 2 % dans la plage spectrale utile.

4. Sous-ensemble selon au moins l'une des revendications 1 à 3, la couche (41, 42) atteignant une transmission de plus de 50 %, de préférence de plus de 80 % dans la plage spectrale appropriée pour le durcissement.

5. Sous-ensemble selon au moins l'une des revendications 1 à 4, la couche (41, 42) présentant une constante de transmission comprise entre la plage spectrale utile et la plage spectrale de préférence à ondes plus grandes appropriée pour le durcissement.

6. Sous-ensemble selon au moins l'une des revendications 1 à 5, la couche (41, 42) dans le composant transparent (1) réfléchissant moins de 10 %.

7. Sous-ensemble selon au moins l'une des revendications 1 à 6, la plage spectrale utile comprenant les lignes du laser Excimer à 248 nm ou à 193 nm et la plage spectrale appropriée pour le durcissement de l'adhésif comprenant la ligne Hg-I à 365 nm.

8. Sous-ensemble selon au moins l'une des revendications 1 à 7, la couche (41, 42) étant réalisée par vaporisation, pulvérisation, précipitation PVD ou précipitation CUD.

9. Sous-ensemble selon au moins l'une des revendications 1 à 8, la couche (41, 42) étant composée de pentoxyde de tantale, de dioxyde d'hafnium, de dioxyde de titane, de sulfure de zinc, de fluorure cérique, de cryolithe ou de fluorure de magnésium ou de mélanges de ces matières.

10. Sous-ensemble selon la revendication 9, la couche (41, 42) étant appliquée lorsque la température du composant transparent est inférieure à 100°C.

11. Sous-ensemble selon au moins l'une des revendications 1 à 10, le composant transparent (1) étant composé de verre quartzeux, de fluorure de calcium ou de dioxyde de germanium.

12. Procédé de fabrication pour un composant optique transparent (1) collé à une monture (2) à l'aide d'un adhésif (31, 32) durcissable par rayonnement UV, **caractérisé en ce que** le composant (1) est muni dans la zone du collage (31, 32) d'une mince couche (41, 42) en technologie de couche mince, laquelle transmet la lumière appropriée pour le durcissement de l'adhésif (31, 32) et réfléchit ou absorbe fortement la lumière UV issue d'une plage spectrale utile, laquelle est de préférence à ondes plus courtes.

13. Procédé selon la revendication 12, la couche mince (41, 42) étant une couche simple.

14. Procédé selon la revendication 12 ou 13, le revêtement étant effectué par vaporisation ou pulvérisation avec ou sans assistance ionique, par PVD ou CUD.

15. Utilisation d'un sous-ensemble selon au moins l'une des revendications 1 à 11 dans un équipement d'éclairage pour projection microlithographique.

16. Utilisation d'un sous-ensemble selon au moins l'une des revendications 1 à 11 en tant que composant pour laser DUV, notamment en tant que fenêtre de sortie.
